(19) Europäisches Patentamt
European Patent Office
Office européen des brevets

(11) Veröffentlichungsnummer: **0 318 020 B1**

(12) **EUROPÄISCHE PATENTSCHRIFT**

(45) Veröffentlichungstag der Patentschrift: **29.07.92**

(51) Int. Cl.[5]: **H01L 23/00**

(21) Anmeldenummer: **88119625.7**

(22) Anmeldetag: **24.11.88**

# (54) Strahlenschutzabdeckung für elektronische Bauelemente.

(30) Priorität: **26.11.87 DE 3740168**

(43) Veröffentlichungstag der Anmeldung:
**31.05.89 Patentblatt 89/22**

(45) Bekanntmachung des Hinweises auf die Patenterteilung:
**29.07.92 Patentblatt 92/31**

(84) Benannte Vertragsstaaten:
**AT DE FR GB IT NL**

(56) Entgegenhaltungen:
**US-A- 3 711 389**

**RUSSIAN CHEMICAL REVIEWS, Band 50, Nr. 12, Dezember 1981, Seiten 1186-1200, Letelworth, Herts, GB; V.V. KIREEV et al.: "Oligomeric alkoxyphosphazens"**

**PATENT ABSTRACTS OF JAPAN, Band 10, Nr. 133 (E-404)[2190], 17. Mai 1986; & JP-A-60 262 429**

(73) Patentinhaber: **SIEMENS AKTIENGESELLSCHAFT**
**Wittelsbacherplatz 2**
**W-8000 München 2(DE)**

(72) Erfinder: **Nuyken, Oskar, Prof.Dr.**
**Ignaz-Günther-Strasse 12**
**W-8000 München 81(DE)**
Erfinder: **Süfke, Thomas, Dipl.-Chem.**
**Situlistrasse 44**
**W-8000 München 45(DE)**
Erfinder: **Budde, Klaus, Dr.**
**Ottobrunner Strasse 5**
**W-8025 Unterhaching(DE)**
Erfinder: **Ouella, Ferdinand, Dr.-Ing.**
**Cramer-Klett-Strasse 2**
**W-8014 Neubiberg(DE)**

EP 0 318 020 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Abdeckschicht für mikroelektronische Bauelemente und höchstintegrierte Schaltungen mit hohem Absorptionsvermögen für Alphastrahlung.

Im Zuge der zunehmenden Miniaturisierung von höchstintegrierten Schaltungen werden neben den Geometrien auch die elektrischen Werte, wie zum Beispiel die Kapazität einer als Kondensator aufgebauten Speicherzelle auf einen minimalen Wert reduziert. Dadurch werden derartige Schaltungen auch zunehmend anfälliger gegen äußere Störungen, wie zum Beispiel radioaktive Strahlung. Vor allem die stark ionisierende Alphastrahlung kann in Speicherzellen enthaltenden Schaltungen das Verfälschen und Löschen von als Ladungen gespeicherten Daten bewirken.

Als Schutz gegen Alphastrahlung "von innen" werden für derartige Schaltungen hochreine Ausgangsmaterialien verwendet, die nur minimale Verunreinigungen an radioaktiven Elementen bzw. Isotopen aufweisen. Zum Schutz gegen "äußere Strahlung" werden die Schaltungen mit Strahlenschutzabdeckschichten versehen.

Diese Schichten werden gemäß Pat. Abstr. of Jap., 10, (1986), Nr. 13 -JP-A-60262429 aus ungesättigten, photopolymerisierbaren, 2 oder mehr terminalen Ethylen-Gruppen enthaltenden Verbindungen hergestellt oder üblicherweise aus photovernetzbaren Polyimidlacken gefertigt und gewähren ab einer Schichtdikke von ca. 30 µm einen sicheren Schutz der Schaltung gegen Alphastrahlen.

Doch weisen diese Schichten noch verschiedene Nachteile auf. In einem Verfahren zum Aufbringen dieser Schichten wird das "rohe" unvernetzte Polyimidharz ganzflächig auf den die Schaltung enthaltenden Wafer aufgebracht. Mittels UV-Licht wird die Harzschicht dann in den dafür vorgesehenen Bereichen über den Schaltungen (nur über den späteren Chips) vernetzt und schließlich entwickelt. Nach Ablösen der unbelichteten Bereiche wird die verbleibende Polyimidschicht in einer mehrstündigen Temperaturbehandlung bis ca. 250 °C nachgehärtet. Bei diesem Temperprozeß tritt eine Schrumpfung der Polyimidschichten auf, die bis zu 50 % des ursprünglichen Volumens betragen kann. Dadurch wird auch die darunterliegende Schaltung mechanisch belastet und kann dabei beschädigt oder gar zerstört werden.

Aus der US-A-3 711 385 sind durch ionisierende Bestrahlung behandelte Phosphozene beschrieben, welche Flammschutzeigenschaften sowie lösungsmittelresistente Eigenschaften aufweisen.

Aufgabe der vorliegenden Erfindung ist es daher, eine hochwärmebeständige Abdeckschicht für mikroelektronische Bauelemente anzugeben, die sowohl einen guten Alphastrahlenschutz gewährleistet, als auch in einem einfachen und schnellen Verfahren aufzubringen ist und keine Schrumpfung bei der Härtung zeigt.

Diese Aufgabe wird durch eine Abdeckschicht der eingangs erwähnten Art erfindungsgemäß dadurch gelöst, daß die Abdeckschicht durch eine mittels UV-Licht initiierte Vernetzung einer Negativresistschicht erzeugt wird, wobei der Negativrest als wesentlichen, die Alphastrahlung absorbierenden Bestandteil ein von der allgemeinen Struktur (I) abgeleitetes Phosphazen enthält,

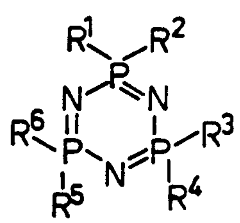

(I)

in dem die jeweils über Sauerstoffatome an den Phosphor gebundenen Reste R1 bis R6 unabhängig voneinander ausgewählt sind aus den Anionen von Alkoholaten, Phenolaten und Carboxylaten mit der Maßgabe, daß mindestens einer der Reste R1 bis R6 eine unter Lichteinwirkung polymerisationsfähige olefinisch ungesättigte Gruppe trägt.

Weiterhin liegt es im Rahmen der Erfindung, daß die die lichtempfindlichen Gruppen tragenden Reste substituierte Acrylatgruppierungen sind.

Weitere Ausgestaltungen der Erfindung ergeben sich aus den Unteransprüchen.

Vom Hexachlortriphosphazen abgeleitete Organopolyphosphazene sind schon lange als "anorganischer Kautschuk" bekannt und finden vielseitige Verwendung als Elastomere in Homo- und Copolymeren. Eine Übersicht über die Darstellung und Eigenschaften von zum Beispiel Fluoralkylpolyphosphazenen findet sich in dem Buch "New Commercial Polymers" von H.-G. Elias, Seiten 164 bis 169 (London 1977).

Neu ist es dagegen, Phosphazene geeignet zu substituieren, mit lichtempfindlichen Gruppen zu verknüpfen und in Negativresists als Strahlenschutzbestandteil einzusetzen. Dieser Strahlenschutz leitet sich aus den gegenüber anderen lichtempfindlichen Polymeren hohen Atommassen der das Polymer aufbauenden Elemente, insbesondere des Phosphors ab.

Zum Herstellen eines einsatzfähigen Negativresists werden die erfindungsgemäßen Phosphazene zusammen mit Photoinitiatoren, gegebenenfalls Vernetzungsverstärkern und anderen üblichen Zusätzen vermengt.

Der fertige Resist wird ganzflächig auf dem die integrierten Schaltungen enthaltenden Wafer zum Beispiel durch Aufschleudern aufgebracht, getrocknet, mit UV-Licht strukturiert bzw. vernetzt und schließlich entwickelt. Die vernetzten Resiststrukturen benötigen keine weitere Härtung und zeigen aufgrund des hohen Vernetzungsgrades eine bemerkenswerte thermische Stabilität. Wegen des niedrigen Verhältnisses der lichtempfindlichen Gruppen in (unvernetztem) Phosphazen zur Molekülgröße des Phosphazens tritt beim Härten der Resistschicht nur eine sehr geringe Schrumpfung auf. Ausreichender Alphastrahlenschutz wird bereits bei Schichtdicken von ca. 15 bis 30 $\mu$m erreicht.

Als lichtempfindliche Gruppen ausgewählte Acrylsäuren, die direkt mit dem als Ausgangsmaterial eingesetzten Hexachlortriphosphazen verestert werden können, sind Zimtsäure, Furanacrylsäure und ähnliche bevorzugt, da mit diesen Säuren eine ausreichend gute Lichtempfindlichkeit und infolgedessen auch eine ausreichend hohe Vernetzungsgeschwindigkeit des Negativresists erzielt wird. Doch sind auch Säuren wie Acryl-oder Methacrylsäure oder Derivate der genannten Verbindungen geeignet.

Die Anzahl lichtempfindlicher Gruppen pro Phospazenmolekül darf nicht zu hoch eingestellt werden, da die Produkte sonst zur Eigenvernetzung neigen. Besonders bevorzugt sind im statistischen Mittel 1 bis 3 lichtempfindliche Gruppen tragende Reste pro Phosphazenring, wobei die übrigen Reste vorteilhafterweise Phenolatgruppen sind.

Auch durch Umsetzung des Hexachlortriphosphazen mit einer Mischung von lichtempfindlichen und nicht lichtempfindlichen Alkoholen läßt sich ein Phospazen I erhalten, dessen Lichtempfindlichkeit und Vernetzungsfähigkeit über das Alkoholatmischungsverhältnis eingestellt werden können. Geeignete Kombinationen stellen zum Beispiel Gemische der Natriumalkoholate von Allyl-und Benzylalkohol im Molverhältnis von 1 : 3 bis 1 : 6 dar.

Eine weitere vorteilhafte Ausgestaltung der Erfindung vermeidet eine Eigenvernetzung, indem jeweils die zwei an ein und dasselbe Phosphoratom gebundenen Reste mit dem Phosphoratom zusammen einen (n + 4)-gliedrigen Heterozyklus bilden und die der allgemeinen Phosphazenstruktur (I) gehorchende Modifikation (II) darstellen:

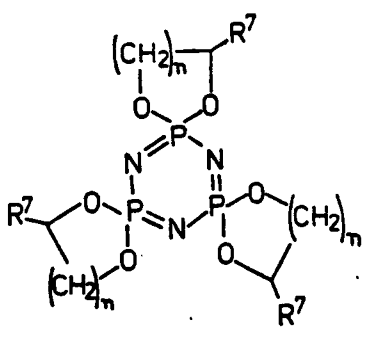

(II)

in der n eine ganze Zahl mit 1 ≦ n ≦ 3 darstellt und der Rest R7 die lichtempfindliche Gruppe trägt, welche aus den oben erwähnten Verbindungen ausgewählt ist. Durch derart mit zweizähnigen Resten substituierte Phosphoratome trägt jeder Phosphazenring genau drei identische Reste R7 mit lichtempfindlichen Gruppen, wodurch die Gefahr der Eigenvernetzung deutlich reduziert ist.

Weitere strukturelle Verbesserungen der erfindungsgemäßen Abdeckschicht lassen sich durch Zumischen weiterer UV-härtbarer Resistmaterialien erzielen. Werden dazu geeignete Resistmischungen gewählt, die für sich bereits gute dielektrische und thermische Eigenschaften aufweisen, so lassen sich diese auch auf Mischungen mit Phosphazen übertragen und in vorteilhafter Weise mit deren guter Alphastrahlenschutzwirkung kombinieren.

Für die Auswahl geeigneter Resists ist die chemische Natur der Reste R1 bis R7 am Phosphazen entscheidend, insbesondere die Art der lichtempfindlichen Gruppe. Ist diese zum Beispiel ein Ester der Zimtsäure, der Furanacrylsäure oder einer ihrer Abkömmlinge, so weist die am besten geeignete Resistzumischung ebenfalls diese Gruppen auf. Insbesondere durch eine Zugabe von Polymeren des Araldit®-Typs,

die durch Reaktion von Bisphenolen mit Epichlorhydrin und anschließender Veresterung mit lichtempfindlichen Acrylsäuren erhältlich und zum Beispiel aus der deutschen Patentanmeldung DE-A-37 08 057.1 bekannt sind, wird eine brauchbare Kombination für eine Abdeckschicht erzielt.

Doch sind auch Kombinationen mit anderen Resists denkbar, sofern eine chemische Verwandtschaft mit den lichtempfindlichen Resten R gegeben ist. Dabei kann das Phospazen sowohl den mengenmäßig größten Anteil der Resistmischung darstellen, als auch nur in einem geringeren Anteil enthalten sein. Die variierbare Anzahl der an den Phosphazenring gebundenen lichtempfindlichen Gruppen ermöglicht auch einen Einsatz als reaktiver Verdünner in UV-härtenden Formulierungen, wodurch der Vernetzungsgrad einer solchen Mischung beeinflußt und thermische und mechanische Eigenschaften der Abdeckschicht verbessert werden können.

Im folgenden wird die Herstellung eines für die erfindungsgemäße Abdeckschicht bevorzugt verwendeten Phosphazens anhand eines Formelschemas und der entsprechenden Synthesevorschriften näher beschrieben.

Ausgehend von als 1,3-Dioxolan geschütztem Glycerin III wird mit Zimtsäurechlorid der entsprechende Ester IV erhalten. Von diesem wird die Schutzgruppe Aceton abgespalten und der so erhaltene Ester V schließlich mit Hexachlortriphosphazen zum lichtempfindlich eingestellten Phospazen VI umgesetzt.

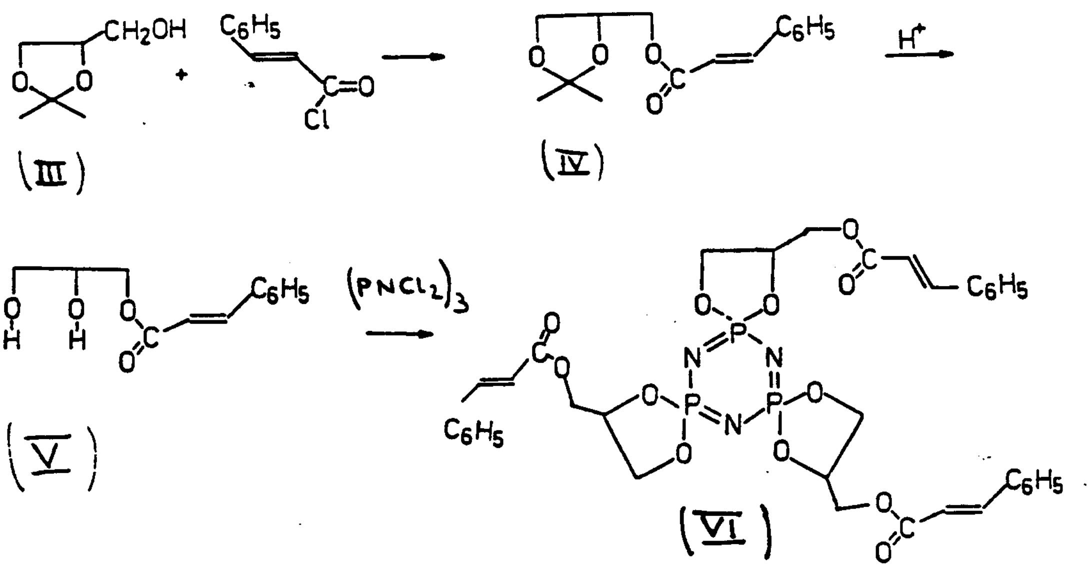


Synthese des Phosphazen VI

Zu äquimolaren Mengen ± 2,2-Dimethyl-4-hydroxymethyl-1,3-dioxolan (III) und trockenem Pyridin in absolutem Toluol wird unter Kühlung bei 0° C eine entsprechende Menge Zimtsäurechlorid in absolutem Toluol getropft und mehrere Stunden bei langsam auf Raumtemperatur steigender Temperatur gerührt. Es wird in üblicher Weise aufgearbeitet und schließlich das Produkt IV erhalten, das chromatographisch über Kieselgel gereinigt werden kann.

Mittels 1-N-Schwefelsäure wird das Ketal IV bei 90°C verseift, wobei man nach üblicher Aufarbeitung den Glycerin-1-Zimtsäureester V erhält.

Bei -15° wird der Ester V mit Hexachlortriphosphazen und einer Base umgesetzt, mehrere Stunden bei Raumtemperatur gerührt und schließlich in üblicher Weise aufgearbeitet. Nach Waschen und Trocknen verbleibt ein farbloser klebriger Feststoff, der aufgrund des racemischen Eduktes V und der Spirostrukturen aus den verschiedenen Diastereomeren des Phosphazens VI besteht.

**Patentansprüche**

1. Abdeckschicht für mikroelektronische Bauelemente und höchstintegrierte Schaltungen mit hohem Absorptionsvermögen für Alphastrahlung, **dadurch gekennzeichnet,** daß die Abdeckschicht durch eine mittels UV-Licht initiierte Vernetzung einer Negativresistschicht erzeugt wird, wobei der Negativresist als wesentlichen, die Alphastrahlung absorbierenden Bestandteil ein von der allgemeinen Struktur (I) abgeleitetes Phosphazen enthält,

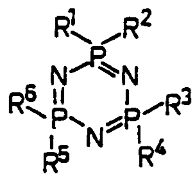

(I)

in dem die jeweils über Sauerstoffatome an den Phosphor gebundenen Reste R1 bis R6 unabhängig voneinander ausgewählt sind aus den Anionen von Alkoholaten, Phenolaten und Carboxylaten mit der Maßgabe, daß mindestens einer der Reste R1 bis R6 eine unter Lichteinwirkung polymerisationsfähige olefinisch ungesättigte Gruppe trägt.

2. Abdeckschicht für mikroelektronische Bauelemente und höchstintegrierte Schaltungen mit hohem Absorptionsvermögen für Alphastrahlung, **dadurch gekennzeichnet,** daß die Abdeckschicht durch eine mittels UV-Licht initiierte Vernetzung einer Negativresistschicht erzeugt wird, wobei der Negativresist als wesentlichen, die Alphastrahlung absorbierenden Bestandteil ein von der allgemeinen Struktur (II) abgeleitetes Phosphazen enthält,

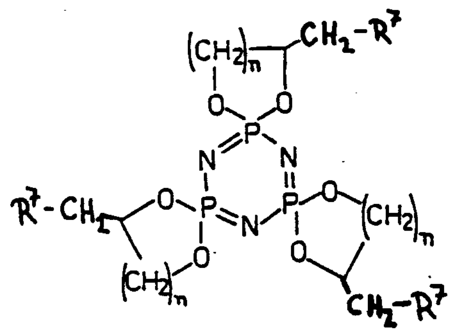

(II)

in der n eine ganze Zahl mit 1 kleiner gleich n kleiner gleich 3 ist und R7 ein Carboxylatrest von (Meth)Acrylsäure, Zimtsäure oder Furanacrylsäure ist.

3. Abdeckschicht nach Anspruch 1, **dadurch gekennzeichnet,** daß der die olefinisch ungesättigte Gruppe tragende Rest ausgewählt ist aus Allylalkoholat, (Meth)Acrylat, Furanacrylat und dem Anion von Zimtsäure.

4. Abdeckschicht nach mindestens einem der Ansprüche 1 bis 3, **dadurch gekennzeichnet,** daß pro Phosphazen 1 bis 3 Reste gebunden sind, die olefinisch ungesättigtre Gruppen tragen.

5. Abdeckschicht nach Anspruch 4, **dadurch gekennzeichnet,** daß die übrigen, nicht olefinisch ungesättigten Gruppen tragenden Reste am Phosphazen Phenolatgruppen sind.

## Claims

1. Cover layer for microelectronic components and VLSI circuits having a high absorptive capacity for $\alpha$-radiation, characterised in that the cover layer is produced by a crosslinking, initiated by means of UV light, of a negative resist layer, the negative resist containing, as essential $\alpha$-radiation-absorbing constituent, a phosphazene derived from the general structure (I)

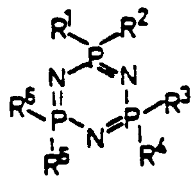

(I)

in which the radicals R1 to R6, each bound via an oxygen atom to the phosphorus, are selected, independently of one another, from the anions of alcoholates, phenolates and carboxylates, with the proviso that at least one of the radicals R1 to R6 carries an olefinically unsaturated group capable of polymerisation on exposure to light.

**2.** Cover layer for microelectronic components and VLSI circuits having a high absorptive capacity for $\alpha$-radiation, characterised in that the cover layer is produced by a crosslinking, initiated by means of UV light, of a negative resist layer, the negative resist containing, as essential $\alpha$-radiation-absorbing constituent, a phosphazene derived from the general structure (II)

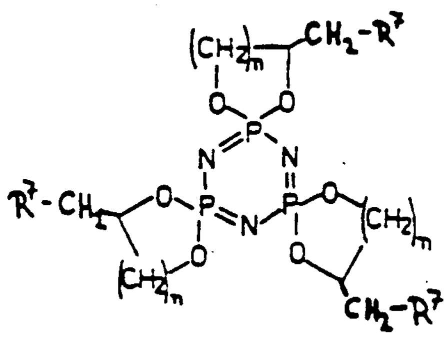

(II)

in which n is an integer with 1 less than/equal to n less than/equal to 3 and R7 is a carboxylate radical of (meth)acrylic acid, cinnamic acid or furylacrylic acid.

**3.** Cover layer according to Claim 1, characterised in that the radical carrying the olefinically unsaturated group is selected from allyl alcoholate, (meth)acrylate, furylacrylate and the anion of cinnamic acid.

**4.** Cover layer according to at least one of Claims 1 to 3, characterised in that 1 to 3 radicals which carry olefinically unsaturated groups are bound per phosphazene.

**5.** Cover layer according to Claim 4, characterised in that the other radicals on the phosphazene which do not carry olefinically unsaturated groups are phenolate groups.

## Revendications

**1.** Couche de revêtement pour des composants de la microélectronique et des circuits à très haute densité d'intégration, possédant un pouvoir d'absorption du rayonnement alpha, caractérisée par le fait que la couche de revêtement est produite par une réticulation, initiée à l'aide d'une lumière ultraviolette, d'une couche de réserve à effet négatif, qui contient, en tant que constituant essentiel absorbant le rayonnement alpha, un phosphazène de formule développée (I)

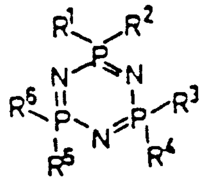

(I)

dans lequel les radicaux R1 à R6, liés au phosphore respectivement par des atomes d'oxygène, sont choisis indépendamment les uns des autres parmi des anions d'alcoolates, de phénolates et de carboxylates, dans la mesure où au moins l'un des radicaux R1 à R6 porte un groupe à insaturation oléfinique polymérisable sous l'action de la lumière.

2. Couche de revêtement pour des composants de la microélectronique et des circuits à très haute densité d'intégration, possédant un pouvoir d'absorption du rayonnement alpha, caractérisée par le fait que la couche de revêtement est produite par une réticulation, initiée à l'aide d'une lumière ultraviolette, d'une couche de réserve à effet négatif, qui contient, en tant que constituant essentiel absorbant le rayonnement alpha, un phosphazène de formule dévelopée (II)

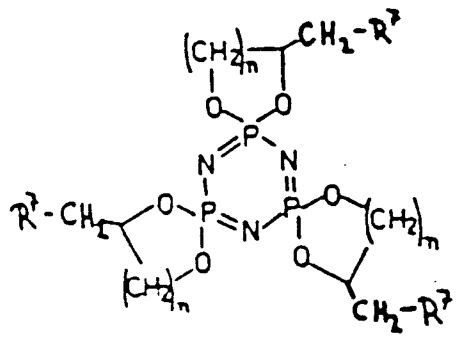

(II)

dans lequel n est un nombre entier, supérieur ou égal à 1 et inférieur ou égal à 3, R7 étant un radical carboxylate de l'acide acrylique, de l'acide methacrylique, de l'acide cinnamique ou de l'acide furane-acrylique.

3. Couche de revêtement suivant la revendication 1, caractérisée par le fait que le radical portant le groupe à insaturation oléfinique est choisi parmi un alcoolate allylique, un acrylate, un méthacrylate, le furane-acrylate et l'anion de l'acide cinnamique.

4. Couche de revêtement suivant au moins l'une des revendications 1 à 3, caractérisée par le fait que de 1 à 3 radicaux à insaturation oléfinique, sont liés dans chaque phosphazène.

5. Couche de revêtement suivant la revendication 4, caractérisée par le fait que les autres radicaux du phosphazène, qui portent des groupes à insaturation non oléfinique, sont des groupes phénolates.